# EUROPÄISCHE PATENTSCHRIFT

(11) **EP 0 829 087 B1**
(45) Veröffentlichungstag und Bekanntmachung des Hinweises auf die Patenterteilung: **28.04.1999**
(21) Anmeldenummer: 96914856.8
(22) Anmeldetag: 13.05.1996
(51) Int. Cl.: G11C 16/06, G11C 8/00

(54) **VERFAHREN ZUR SELEKTIVEN PROGRAMMIERUNG EINES NICHT-FLÜCHTIGEN SPEICHERS**
PROCESS FOR THE SELECTIVE PROGRAMMING OF A NON-VOLATILE STORE
PROCEDE DE PROGRAMMATION SELECTIVE D'UNE MEMOIRE NON VOLATILE

(30) Priorität: 30.05.1995 DE 19519774
(43) Veröffentlichungstag der Anmeldung: 18.03.1998
(73) Patentinhaber: SIEMENS AKTIENGESELLSCHAFT, 80333 München (DE)
(72) Erfinder: TEMPEL, Georg, D-81927 München (DE)
(86) Internationale Anmeldenummer: DE9600834
(87) Internationale Veröffentlichungsnummer: WO9638847

(56) Entgegenhaltungen:
- US-A- 5 311 480
- US-A- 5 357 463
- IEEE JOURNAL OF SOLID-STATE CIRCUITS, Bd. 27, Nr. 11, November 1992, NEW YORK US, Seiten 1547-1553, XP000320441 JINBO ET AL: "A 5V-only 16Mb flash memory with sector erase mode"

## Beschreibung

Programmierbare nicht-flüchtige Speicherzellen weisen eine sich in elektrisch schwebendem Zustand befindende Gate-Elektrode, das sogenannte "Floating Gate" auf. Dieses "Floating Gate" ist durch isolierende Oxidschichten sowohl von dem Kanalbereich der Speicherzelle, die ansonsten wie ein MOSFET aufgebaut ist, als auch von deren Steuergate-Elektrode getrennt und zwischen diesen angeordnet.

Eine Programmierung der Zelle erfolgt nun dadurch, daß eine Ladung auf das schwebende Gate aufgebracht wird. Durch diese Ladung wird die Einsatzspannung, also die Spannung, bei der der die Speicherzelle bildende MOSFET zu leiten beginnt, verändert. Beim Lesen der Zelle wird dann eine Spannung an das Steuergate angelegt, die einen Wert aufweist, der zwischen den Einsatzspannungen einer nicht programmierten und einer programmierten Zelle liegt. Abhangig davon, ob dann ein Strom fließt, wird entweder eine logische "0" oder eine logische "1" ausgelesen.

Es sind bisher zwei Verfahren bekannt, wie die Ladungen auf das "Floating Gate" gebracht werden können. Beim ersten wird an das Steuergate eine hohe positive Spannung von etwa 12 V angelegt, wahrend an die Drain und die Source des die Speicherzelle bildenden MOSFETs etwa typisch 7 V bzw. 0 V, also die für MOS-Schaltungen üblichen Betriebsspannungen, angelegt werden. Dadurch fließt ein starker Strom durch den Kanal des MOSFETs, aus dem sogenannte "heiße" Elektronen auf das "Floating Gate" gelangen.

Beim anderen Verfahren wird an das Steuergate eine hohe negative Spannung von etwa -12 V und an die Drain eine Spannung von etwa 5 V angelegt. Dadurch tunneln Löcher durch das Gateoxid zum "Floating Gate" und laden dieses positiv auf, wodurch die Einsatzspannung des die Speicherzelle bildenden MOSFETs sinkt.

Dieses Verfahren hat zwar den Vorteil, daß beim Laden des "Floating Gates" kein Verluststrom durch den Kanal fließt, bereitet aber das Problem, eine hohe negative Spannung selektiv an die auszuwählende wortleitung schalten zu müssen. Ein herkömmlicher n-Kanal-MOSFET kann hier nicht verwendet werden, da dessen n-dotierte Drain- oder Sourcegebiete bei Anlegen einer negativen Spannung einen Quasi-Kurzschluß zum mit Masse verbundenen p-dotierten Substrat bilden würden.

Es ist deshalb üblich, zu diesem Zweck n-Kanal-MOSFETs in einer durch eine tiefe n-dotierte Wanne gelegenen p-dotierten Wanne anzuordnen. Hier ist jedoch ein zusätzlicher Technologieaufwand, spezielles Equipment wie Hochenergie-Implanter und das Risiko eventueller Aufladungen der isolierten Wanne und damit verbundenem Gateoxid-Streß während der Prozessierung gegeben.

Eine andere Lösung ist aus der EP 0 456 623 A2 bekannt. Dort wird die hohe negative Spannung über p-Kanal-MOSFETs an die Wortleitung eines nicht-flüchtigen Speichers geschaltet. Diese p-MOSFETs können zwar in herkömmlicher Technologie hergestellt werden, bedürfen aber einer negativen Gatespannung zum Schalten. Diese wird durch Spannungsinverterschaltungen aus einer positiven Hochspannung erzeugt. Allerdings sind diese Spannungsinverterschaltungen für jede wortleitung nötig, was einen erheblichen schaltungstechnischen Aufwand erfordert.

Aus der US-A-5 311 480 ist ein Verfahren bekannt, bei dem an alle nicht selektierten Wortleitungen über ein Isolationselement eine positive Spannung angelegt und gleichzeitig nur die selektierte Wortleitung durch eine ihr zugeordnete Ladungspumpe auf ein negatives Potential gezogen wird. Dies hat jedoch einen relativ großen Stromverbrauch zur Folge.

Die Aufgabe vorliegender Erfindung ist es also, ein Verfahren zum selektiven Anlegen einer negativen Programmierspannung an eine Wortleitung eines nicht-flüchtigen Speichers anzugeben, bei dem die obengenannten Nachteile vermieden werden.

Die Aufgabe wird durch ein Verfahren gemäß Anspruch 1 gelöst.

Bei dem erfindungsgemäßen Verfahren wird die negative Spannung an alle Wortleitungen gleichzeitig, beispielsweise über jeweils einen als Diode geschalteten PMOS-Transistor, angelegt. Es ist also kein selektives Schalten der hohen negativen Spannung nötig. Hierdurch wird eine Vereinfachung der Technologie und Schaltungstechnik im nicht-flüchtigen Speicherbaustein erreicht, da nur Standardschaltungstechniken erforderlich sind. Es ist auch nur eine Standardtechnologie erforderlich, da keine spezielle Isolation des Substrats zu negativen Spannungen notwendig ist.

Eine Selektion einer einzelnen Wortleitung erfolgt in erfindungsgemäßer Weise durch Kompensation der negativen Ladungen auf allen nicht selektierten Wortleitungen. Dies erfolgt durch Anlegen einer positiven Spannung an diese Wortleitungen, also einer Spannung, die ohnehin vorhanden ist. Ein Schalten positiver Spannungen bereitet keine Probleme der obengenannten Art.

Die Erfindung wird nachfolgend anhand eines Ausführungsbeispiels mit Hilfe von Figuren näher erläutert. Dabei zeigen:
- Figur 1: eine schematische Darstellung eines nicht-flüchtigen Speichers zur Durchführung des erfindungsgemäßen Verfahrens und
- Figur 2: ein Zeitdiagramm zur Veranschaulichung des erfindungsgemäßen Verfahrens.

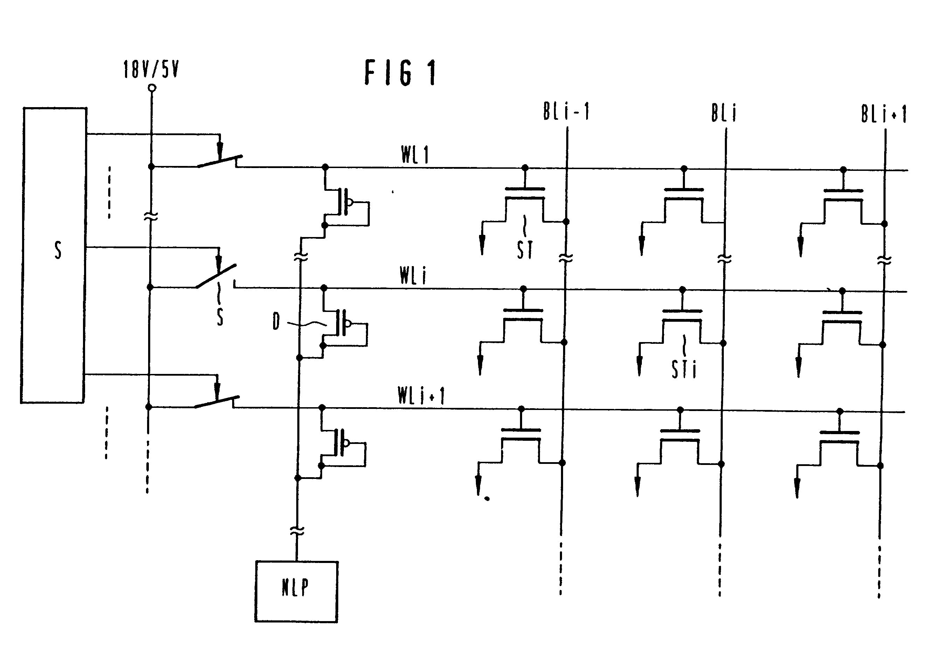

Der in Figur 1 in schematischer Weise dargestellte nichtflüchtige Speicher zeigt ein Speicherzellenfeld mit in Reihen und Spalten angeordneten Speicherzellen ST. Die Speicherzellen ST können über Wortleitungen WL1...WLi, WLi+1... und Bitleitungen ...BLi-1, BLi, BLi+1... ausgewählt werden, um programmiert, gelöscht und gelesen zu werden. Zum Programmieren einer bestimmten Speicherzelle STi muß an die entsprechende Wortleitung WLi eine hohe negative Programmierspannung und an die entsprechende Bitleitung BLi die übliche positive Versorgungsspannung für MOS-Schaltungen von beispielsweise etwa 5 V angelegt werden. Die hohe negative Spannung wird von einer negativen Ladungspumpe NLP erzeugt und über Dioden D, die mit PMOS-Transistoren gebildet sind, an alle Wortleitungen WL1...WLi, WLi+1... gleichzeitig angelegt. Alle Wortleitung WL1...WLi, WLi+1... sind über Schalter S mit einer hohen positiven Spannung von beispielsweise etwa 18 V oder mit der Versorgungsspannung von beispielsweise etwa 5 V verbindbar. Die Schalter S sind von einer Schaltungsanordnung SEL zum Auswählen einer Wortleitung ansteuerbar. Sie können beispielsweise mit CMOS-Invertern gebildet sein.

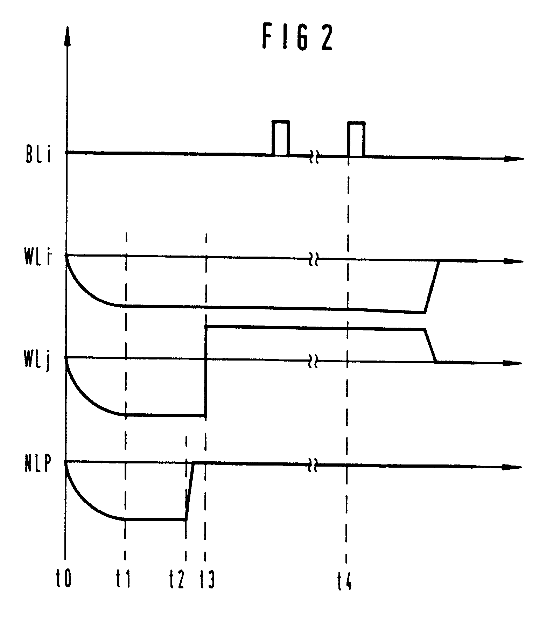

In Figur 2 ist der zeitliche Ablauf des erfindungsgemäßen Verfahrens dargestellt. Zu einem Zeitpunkt t0 wird die negative Ladungspumpe NLP eingeschaltet. Sie erreicht zu einem Zeitpunkt tl die erforderliche hohe Spannung von etwa --12 V. Diese Spannung wird über die Dioden D an alle Wortleitungen WL1...WLi, WLi+1... gleichzeitig angelegt, so daß sich diese auf den negativen Spannungswert aufladen. Dies ist in Figur 2 für die selektierte bzw. ausgewählte Wortleitung WLi und für die nicht ausgewählten Wortleitungen WLj dargestellt. Zum Zeitpunkt t2 wird die negative Ladungspumpe NLP wieder abgeschaltet. Zu einem kurz darauffolgenden Zeitpunkt t3 werden dann die Schalter S aller nicht ausgewählten Wortleitungen WLj geschlossen, so daß diese Wortleitungen WLj mit einer positiven Spannung verbunden sind und die sich darauf befindenden negativen Ladungen dadurch kompensiert werden. Aufgrund der Dioden D haben diese positiven Ladungen keinen Einfluß auf die ausgewählte Wortleitung WLi, so daß diese ihre negative Ladung behält. Die Selbstentladezeit der somit negativ aufgeladenen Wortleitung WLi kann mehrere Sekunden betragen, so daß genügend Zeit zur Verfügung steht, um an der oder den ausgewählten Bitleitungen BLi Programmierimpulse anzulegen, um die ausgewählte(n) Speicherzelle(n) STi zu programmieren. Nachdem zum Zeitpunkt t4 der letzte Programmierimpuls an die Bitleitung BLi angelegt wurde, ist der Programmiervorgang beendet und die Wortleitungen WLi und WLj werden in einen neutralen Zustand gebracht.

## Patentansprüche

1. Verfahren zum selektiven Anlegen einer negativen Programmierspannung an eine wortleitung (WLi) eines nicht-flüchtigen Speichers mit den aufeinanderfolgenden Schritten:
a) Anlegen der negativen Programmierspannung an alle Wortleitungen (WLi, Wlj),
b) Abschalten der negativen Programmierspannung, so daß die Wortleitungen (WLi, Wlj) in einen schwebenden Zustand gebracht werden,
c) Anlegen einer positiven Spannung an alle nicht selektierten Wortleitungen (WLj).

2. Verfahren nach Anspruch 1, **dadurch gekennzeichnet**, daß die negative Programmierspannung über Dioden (D) an die Wortleitungen (WLi, WLj) angelegt wird.

3. Verfahren nach Anspruch 2, **dadurch gekennzeichnet**, daß die Dioden (D) mit PMOS-Transistoren gebildet sind.

## Claims

1. Method for selective application of a negative programming voltage to a word line (WLi) of a nonvolatile memory having the successive steps of:
a) application of the negative programming voltage to all the word lines (WLi, WLj),
b) switching off the negative programming voltage so that the word lines (WLi, WLj) are brought into a floating state,
c) application of a positive voltage to all the non-selected word lines (WLj).

2. Method according to Claim 1, characterized in that the negative programming voltage is applied to the word lines (WLi, WLj) via diodes (D).

3. Method according to Claim 2, characterized in that the diodes (D) are formed using PMOS transistors.

## Revendications

1. Procédé d'application sélective d'une tension de programmation négative à une ligne de mot (WLi) d'une mémoire non volatile, comportant les étapes suivantes :
a) application de la tension de programmation négative à toutes les lignes de mot (WLi, WLj),
b) interruption de la tension de programmation négative de telle sorte que les lignes de mot (WLi, WLj) sont mises dans un état flottant,
c) application d'une tension positive à toutes les lignes de mot (WLj) non sélectionnées.

2. Procédé selon la revendication 1, **caractérisé par le fait que** la tension de programmation négative est appliquée par l'intermédiaire de diodes (D) aux lignes de mots (WLi, WLj).

3. Procédé selon la revendication 2, **caractérisé par le fait que** les diodes (D) sont formées par des transistors PMOS.
